# EUROPEAN PATENT SPECIFICATION

(11) **EP 4 317 954 B1**
(45) Date of publication and mention of the grant of the patent: **09.12.2026**
(21) Application number: 22780512.4
(22) Date of filing: 24.03.2022
(51) Int. Cl.: H10W 40/25, H10W 70/02, B22F 3/00, B22F 7/06, C01B 32/21, C22C 1/04

(54) **GRAPHITE-COPPER COMPOSITE MATERIAL, HEAT SINK MEMBER USING SAME, AND METHOD FOR MANUFACTURING GRAPHITE-COPPER COMPOSITE MATERIAL**
GRAPHIT-KUPFER-VERBUNDMATERIAL, KÜHLKÖRPERELEMENT DAMIT UND VERFAHREN ZUR HERSTELLUNG EINES GRAPHIT-KUPFER-VERBUNDMATERIALS
MATÉRIAU COMPOSITE GRAPHITE-CUIVRE, ÉLÉMENT DE DISSIPATION THERMIQUE L'UTILISANT, ET PROCÉDÉ DE FABRICATION DE MATÉRIAU COMPOSITE GRAPHITE-CUIVRE

(30) Priority: 31.03.2021 JP 2021061152
(43) Date of publication of application: 07.02.2024
(73) Proprietor: UBE Corporation, Ube-shi, Yamaguchi 755-8633 (JP)
(72) Inventor: YOSHIMURA, Masafumi, Ube-shi, Yamaguchi 755-8633 (JP); INAMORI, Dai, Ube-shi, Yamaguchi 755-8633 (JP); SUNAMOTO, Kenichi, Hiroshima-shi, Hiroshima 736-0082 (JP)
(74) Representative: Michalski Hüttermann & Partner mbB
(86) International application number: PCT/JP2022/014138
(87) International publication number: WO 2022/210298

(56) References cited:
- EP-A1- 4 079 426
- WO-A1-2009/051094
- WO-A1-2021/125196
- CN-A- 102 586 704
- JP-A- 2010 248 064
- JP-A- H10 168 502
- JP-A- H10 168 502
- US-A1- 2019 366 429
- US-A1- 2019 366 429

## Description

### Technical Field

The present invention relates to a graphite-copper composite material, a heat sink member using the same, and a method for manufacturing the graphite-copper composite material.

### Background Art

A high thermal conductivity is desired for a material for a heat dissipation component of a semiconductor device. Although copper has a high thermal conductivity, its coefficient of thermal expansion is also high. As a composite material that reduces coefficient of thermal expansion without losing a high thermal conductivity of copper and can be obtained at low cost, a metal-graphite composite material has been proposed (for example, see Patent Literature 1). Patent Literature 1 discloses that the metal-graphite composite material has high cooling reliability and low coefficient of linear expansion.

### Citation List

### Patent Literature

Patent Literature 1: JP 2017-128802 A
Patent Literature 2 : JP H10 168502 A describes a mixture which is prepared by mixing 100 pts.wt. of metal powder (Fe, Cu, Al, Ag, Be, Mg, W, Ni, Mo, Si, Zn, etc.) and 1-200 pts.wt. of crystalline carbon material (graphite, carbon fiber, carbon black, fullerene, carbon nano- tube, etc.).
Patent Literature 3: US 2019/366429 A1 describes a method of manufacturing a metal hybrid heat-dissipating material, the method including (a) preparing spherical metal powder and flake graphite powder having an aspect ratio greater than 1, (b) preparing mixture powder by inserting only the spherical metal powder and the flake graphite powder into a container and then mixing the metal powder and the graphite powder by using a multiaxial mixing method for rotating the container about two or more different rotation axes, (c) manufacturing a green compact by pressing the mixture powder, and (d) sintering the green compact.
Patent Literature 4: EP 4 079 426 A1 describes a graphite-copper composite material that includes: a copper layer having an average thickness of 15 µm or less; and scaly graphite particles laminated with the copper layer interposed therebetween, has a copper volume fraction of 3 to 20%, and includes (A) or (B) below.
Patent Literature 5: CN 102 586 704 A describes a high thermal conductivity graphite whisker/copper composite and a preparation method thereof.

### Summary of Invention

### Technical Problem

To use the metal-graphite composite material as a heat dissipation material, the metal-graphite composite material is provided in a temperature cycle from around -40°C at the minimum to around 125°C at the maximum in some cases. Reducing heat deterioration of the composite material due to the temperature cycle is the conventional problem, but has not been sufficiently solved yet at present.

Therefore, an object of the present invention is to provide a graphite-copper composite material in which heat deterioration after a temperature cycle is reduced, a heat sink member using the same, and a method for manufacturing the graphite-copper composite material.

### Solution to Problem

The invention is defined by the features of the independent claim.

As a result of examination to solve the problem, the present inventor has found that use of scaly graphite particles obtained by performing predetermined pretreatment on graphite particles, as a raw material together with copper particles allows obtaining a graphite-copper composite material in which heat deterioration after a temperature cycle is reduced.

That is, the present invention is a graphite-copper composite material that contains a copper layer and scaly graphite particles stacked via the copper layer. A volume fraction of copper is from 3 to 30%. A number of intra-particle gaps N obtained by the following (1a) to (1c) is five pieces or less in a stacked cross-sectional surface.
(1a) defining five measurement visual fields of 930 µm × 1230 µm in the stacked cross-sectional surface;
(1b) counting the number of gaps having a width of 2 to 5 µm in the scaly graphite particles in each of the five measurement visual fields, and assigning N₁ to N₅ for the five measurement visual fields; and
(1c) calculating an average value of the number of gaps ((N₁ + N₂ + N₃ + N₄ + N₅)/5) to obtain the number of intra-particle gaps N.

Additionally, the present invention is a heat sink member using the above-described graphite-copper composite material.

Furthermore, the present invention is a method for manufacturing the graphite-copper composite material described above including: inserting graphite particles between a pair of grinding stones disposed up and down and rotating a grinding stone on an upper side at 12 Hz or less to perform pretreatment on the graphite particles and to obtain the scaly graphite particles; mixing the scaly graphite particles and copper particles to obtain a raw material for molding; and sintering a molded body, obtained by molding the raw material for molding, by a multi-axis electric current sintering method.

### Advantageous Effects of Invention

The present invention can provide a graphite-copper composite material in which heat deterioration after a temperature cycle is reduced, a heat sink member using the same, and a method for manufacturing the graphite-copper composite material.

### Brief Description of Drawings

FIG. 1 is a drawing illustrating a measurement visual field defined in a SEM image of a stacked cross-sectional surface of a graphite-copper composite material.
FIG. 2 is a drawing describing a gap inside the scaly graphite particle.
FIG. 3 is a drawing describing a pretreatment method of the graphite particles.
FIG. 4 is a schematic diagram describing a multi-axis electric current sintering device.
FIG. 5 is a schematic diagram describing a cooling board.
FIG. 6 is a drawing illustrating an example of transition of a heat deterioration rate in a temperature cycle test.

### Description of Embodiments

The following describes embodiments of the present invention in detail.

### <Graphite-Copper Composite Material>

The graphite-copper composite material of the present invention (hereinafter also simply referred to as a composite material) is a sintered body obtained using scaly graphite particles and copper particles as raw materials. The scaly graphite particles are stacked via a copper layer. Here, "via a copper layer" means that the scaly graphite particles are connected by the adjacent copper layer. That is, the scaly graphite particles in the composite material are electrically continuous. Although the thickness of the copper layer in the composite material is not specifically limited, it is generally around from 3 to 25 µm.

The volume fraction of copper in the composite material is from 3 to 30%. Since the content proportion of the graphite having high thermal conductivity is high, from 70 to 97%, the thermal conductivity of the composite material of the present invention is considerably high. The copper acts as a binder in the composite material. Considering avoiding a rupture of the composite material during processing, the volume ratio between the graphite and the copper in the composite material (graphite:copper) is preferred from 70: 30 to 97: 3. To ensure high thermal conductivity of 750 W/(m·K) or more and satisfactory processability, the volume ratio (graphite:copper) is more preferred from 84:16 to 95:5. The volume fraction of the copper in the composite material can be adjusted by the compounding ratio of the raw materials during manufacturing.

Furthermore, in the composite material of the present invention, the number of intra-particle gaps N obtained by a predetermined method in a stacked cross-sectional surface is five pieces or less. The stacked cross-sectional surface is a cross-sectional surface where the stacked scaly graphite particles are observed and specifically is a surface having a direction in which the stacked scaly graphite particles are pressurized when a raw material for molding containing the scaly graphite particles is sintered to manufacture the composite material.

When the composite material has a column shape, since the vertical direction of the column is equivalent to the direction in which the scaly graphite particles are stacked, first, a plate material having a thickness of around 2 mm is cut out in the vertical direction of the column. After the surface of the cut out plate material is polished, the stacked cross-sectional surface of the analyzed portion is obtained using a Cross section Polisher (CP).

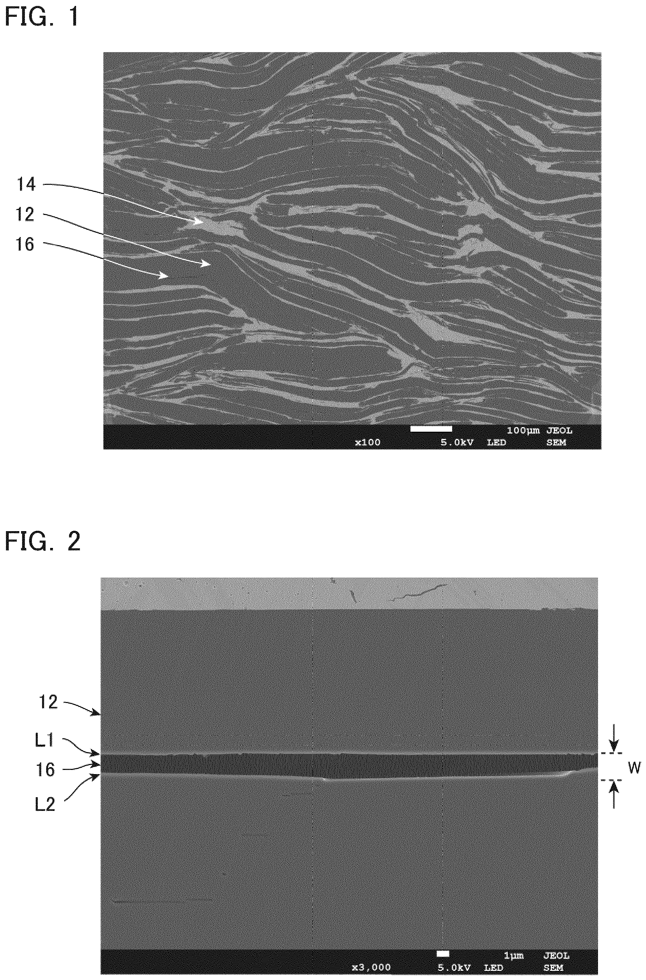

The number of intra-particle gaps N can be obtained by the following (1a) to (1c).
(1a) Five measurement visual fields of 930 µm × 1230 µm are defined in the stacked cross-sectional surface of the composite material. The measurement visual field can be arbitrarily defined in a SEM image obtained by observing the stacked cross-sectional surface of the composite material at a scaling factor of 100 powers by a Scanning Electron Microscope (SEM). As illustrated in FIG. 1, in the measurement visual field, scaly graphite particles 12 are stacked via copper layers 14, and a gap 16 is confirmed in the scaly graphite particles 12.
(1b) In each of the five measurement visual fields, the number of gaps having a width of 2 to 5 µm in the scaly graphite particles is counted, and N₁ to N₅ are assigned for the five measurement visual fields. The width of the gap in the scaly graphite particles is defined as illustrated in FIG. 2. That is, any gap 16 in the scaly graphite particles 12 is selected, and the gap 16 is adjusted to cross the screen. A maximum distance between two sides L1 and L2 defining the top and bottom of the gap 16 is defined as a width w of the gap. The number of the gaps 16 having the width w of 2 to 5 µm is measured and counted by commercially available image processing software to obtain N₁ to N₅. As necessary, the contrast of the SEM image is adjusted appropriately for observation.
(1c) The average value of the number of gaps ((N₁ + N₂ + N₃ + N₄ + N₅)/5) in the five measurement visual fields is calculated to obtain the number of intra-particle gaps N.

In the present invention, the number of intra-particle gaps N thus obtained is regulated to five pieces or less. The present inventors have found that the scaly graphite particles in which the number of intra-particle gaps is five pieces or less have an action of reducing heat deterioration after the temperature cycle of the composite material. The number of intra-particle gaps N is preferred to be 5.0 pieces or less, 3.5 pieces or less is more preferred, and 2.3 pieces or less is especially preferred.

In the composite material of the present invention, the thermal conductivity is preferred to be 700 W/(m·K) or more. The thermal conductivity is a value measured in a direction perpendicular to the direction in which the scaly graphite particles are stacked. To use for an electronic component with high output or the like, the thermal conductivity is more preferred to be 750 W/(m·K) or more. For thermal conductivity, a sample having a predetermined dimension (outer diameter 10 mm × thickness 2.5 mm) from the center portion of the composite material is cut out, measurement is performed using LFA447 manufactured by NETZSCH compliant to a laser flash method (JIS H 7801:2005), and an average of the thermal conductivities of the five samples cut out from the composite material is used.

Additionally, in the composite material of the present invention, the heat deterioration rate obtained by the following (2a) to (2c) is preferred to be 10% or less.

(2a) The sample is prepared by cutting out a plate in the direction in which the scaly graphite particles are stacked.

The sample can be obtained by, for example, processing the plate to have the outer diameter of 10 mm and the thickness of 2.5 mm.

(2b) After a heat diffusion rate TD₀ of the sample is obtained, a cycle of temperature rise/fall from -40°C to 220°C is repeated to obtain a heat diffusion rate TD₅₀₀ after 500 times.

The heat diffusion rate can be obtained with LFA447 manufactured by NETZSCH compliant to the laser flash method (JIS H 7801:2005).

(2c) The heat deterioration rate is obtained by ((TD₀ - TD₅₀₀)/TD₀)) × 100).

The heat deterioration rate serves as an index of resistance of the heat diffusion rate of the composite material, and as the smaller the value is, the better the property is. It can be said that when the heat deterioration rate is up to 10%, the heat deterioration after the temperature cycle is reduced in the material. The heat deterioration rate is more preferred to be 5% or less.

### <Manufacturing Method>

The composite material of the present invention can be manufactured by performing predetermined pretreatment on graphite particles to obtain the desired scaly graphite particles, mixing it with copper particles to produce a raw material for molding, molding the raw material for molding, and sintering it under predetermined conditions. The respective steps will be described below.

### (Pretreatment of Graphite)

The pretreatment of the graphite particles is performed by applying stress to the graphite particles. The graphite particles original internally have gaps caused by stress applied in the manufacturing process. The inventors found that the number of intra-graphite particle gaps is involved in heat deterioration of the composite material containing the graphite particles and made it possible to reduce heat deterioration after the temperature cycle of the composite material by using the scaly graphite particles obtained by performing the predetermined pretreatment.

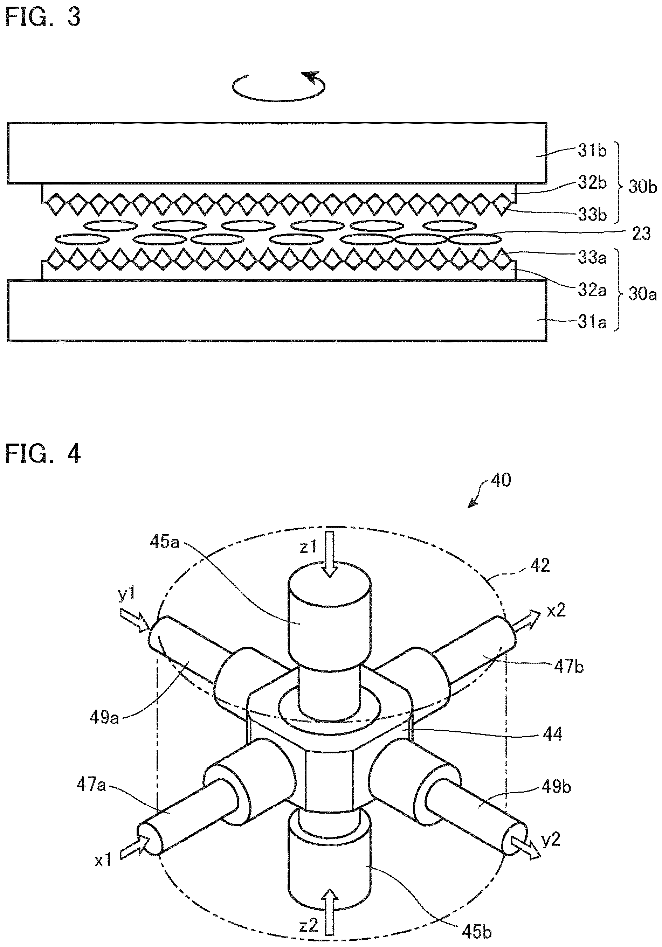

As illustrated in FIG. 3, two grinding stones 30a and 30b can be used for the pretreatment of the graphite particles. The grinding stone 30b is a rotating grinding stone that is rotatable. The grinding stones 30a and 30b include metal plates 31a and 31b, respectively, and include abrasive grains 33a and 33b, such as diamonds, on the opposed surfaces. The abrasive grains 33a and 33b are fixed by joining metal members 32a and 32b, such as plating, and graphite particles 23 to be processed are disposed between the abrasive grains 33a and 33b. The rotating grinding stone 30b is rotated at 12 Hz or less to apply stress to the graphite particles 23. The rotation speed of the rotating grinding stone 30b of 12Hz or less allows obtaining a desired effect.

When stress is applied to the graphite particles, gaps are formed such that a single graphite particle becomes a plurality of particles. It is inferred that regulating the rotation speed of the rotating grinding stone 30b to 12 Hz or less applies adequate stress to the graphite particles and the scaly graphite particles with the small number of gaps can be obtained. Since the pretreatment thins the graphite particles, the graphite particles are referred to as the scaly graphite particles. Note that the rotation speed of the rotating grinding stone 30b is preferred to be 10 Hz or less and more preferred to be 6 Hz or less.

As the condition of the pretreatment of the graphite particles, the rotation speed of the rotating grinding stone 30b only needs to be regulated to 12 Hz or less, and conditions other than that are not especially regulated. For example, the pressure can be around from 0.2 to 0.8 MPa, and the time can be around from 10 to 30 seconds.

### (Preparation of Copper Particles)

The copper particles are not especially regulated, and, for example, copper particles having a median diameter on a volumetric basis of 1.5 µm or less can be used. The median diameter of the copper particles is preferred to be 1.0 µm or less. The use of the copper particles having the small median diameter of 1.5 µm or less allows obtaining the composite material having stable thermal conductivity and processability. The copper particles having the median diameter of 1.5 µm or less can be manufactured by any method. For example, the desired copper particles can be obtained by chemical reduction method and physical manufacturing method.

### (Mixture)

The scaly graphite particles obtained by performing the pretreatment and the copper particles are combined at a predetermined ratio and wet blending is performed with an organic solvent to obtain the raw material for molding. The compounding ratio of the raw material is selected such that the volume ratio between the graphite and the copper (graphite:copper) in the composite material becomes from 70:30 to 97:3. From the aspects of thermal conductivity and processability, the volume ratio (graphite:copper) is preferably selected to be from 84:16 to 95:5. Specifically, the preferred organic solvent includes toluene and xylene.

### (Sintering)

First, the small amount (around 40 g or less) of the raw material for molding is filled in a predetermined molding die, and, for example, powder compacting is performed with a pressure around from 3 to 15 MPa using a hydraulic hand press. As the molding die, for example, a mold made of SUS having a diameter of 30 mm can be used. Filling and powder compacting of the raw material for molding are repeated to manufacture a molded body having a desired size. The obtained molded body is sintered by multi-axis electric current sintering method to obtain the sintered body as the composite material of the present invention.

Here, with reference to FIG. 4, the outline of the multi-axis electric current sintering device will be described. A multi-axis electric current sintering device 40 illustrated in FIG. 4 allows a carbon mold 44, in which the molded body is housed, to be fixed to an inside of a vacuum container 42 with pressurization shafts 45a and 45b in the up-down direction, horizontal heating shafts (A) 47a and 47b, and horizontal heating shafts (B) 49a and 49b. The heating shafts (A) 47a and 47b and the heating shafts (B) 49a and 49b are configured to be alternately energized. The heating shafts (A) are energized in directions of arrows x1 and x2 and the heating shafts (B) are energized in directions of arrows y1 and y2.

In the multi-axis electric current sintering device 40, the pressurization shafts 45a and 45b, and the heating shafts 47a, 47b, 49a, and 49b are separated. Specifically, the pressurization shafts 45a and 45b are in the z-axis direction, the heating shafts (A) 47a and 47b are in the x-axis direction, and the heating shafts (B) 49a and 49b are in the y-axis direction. Since this allows independently controlling pressurization and heating, a uniform temperature distribution can be obtained in the radial direction of the molded body.

In sintering, after the carbon mold 44 in which the molded body is housed is fixed to the inside of the vacuum container 42, the inside of the vacuum container 42 is decompressed to be 100 Pa or less, and to reduce oxidative degradation of a component inside the device, the inside of the vacuum container 42 is preferably decompressed to be 50 Pa or less. Next, first, the heating shafts (A) 47a and 47b are energized to be heated around from 650 to 750°C, and preferred to be around from 670 to 730°C.

Afterwards, the heating shafts (A) 47a and 47b are switched to the heating shafts (B) 49a and 49b, and the heating shafts (B) 49a and 49b are heated to around from 930 to 980°C, and preferred to be around from 940 to 970°C. Furthermore, pressurization is performed in an arrow z1 direction and an arrow z2 direction by the pressurization shafts 45a and 45b in the up-down direction. The pressure at the time is preferred to be around from 10 to 100 MPa and more preferred to be around from 30 to 50 MPa.

Since sintering is performed in the uniform temperature distribution by the multi-axis electric current sintering method, the composite material having the stable quality can be manufactured. Moreover, since the scaly graphite particles obtained by the predetermined pretreatment are used together with the copper particles as the raw material, the number of intra-particle gaps in the stacked cross-sectional surface of the composite material of the present invention obtained by the predetermined method is five pieces or less. By the number of intra-particle gaps being five pieces or less, in the composite material of the present invention, the heat deterioration after the temperature cycle is reduced, and further high thermal conductivity is provided.

The composite material of the present invention can be preferably used as a heatsink (heat sink member). The heat sink member is used in a wide range of fields, such as a wireless communication field, an electronic control field, and an optical communication field. Examples of the application specifically include a power semiconductor module, an optical communication module, a projector, a Peltier cooler, a water cooler, and an LED heat radiation fan.

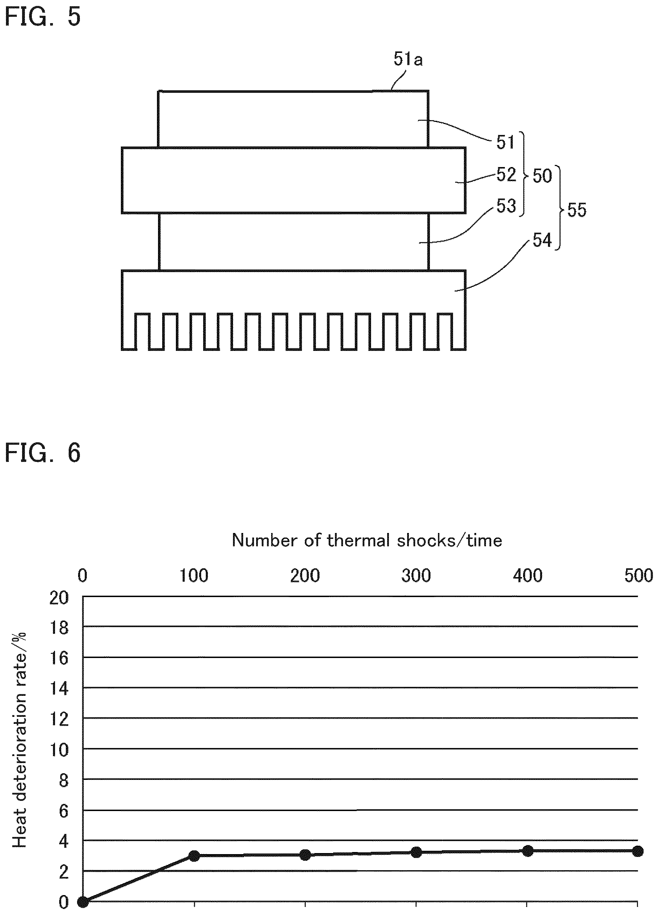

FIG. 5 illustrates an example of the cooling board using the heatsink. A cooling board 55 includes a heatsink 50 and a cooling layer 54. The heatsink 50 includes an electric insulating layer 52 and a wiring layer 51 sequentially stacked on a stress buffer layer 53. On a mounting surface 51a on the upper surface of the wiring layer 51, a pyrogenic element, such as a semiconductor element, is mounted. The composite material of the present invention can be used for at least one layer of the stress buffer layer 53 and the wiring layer 51.

The heat generated in the pyrogenic element mounted on the mounting surface 51a of the heatsink 50 is sequentially conducted through the wiring layer 51, the electric insulating layer 52, the stress buffer layer 53, and the cooling layer 54, and is dissipated from the cooling layer 54. Since the heat deterioration after the temperature cycle is reduced in the composite material of the present invention, the pyrogenic element can be efficiently cooled to reduce the temperature, and also the effect is stably exerted over a long period of time.

### Examples

Next, the present invention will be specifically described with the examples, but the present invention is not limited to the following examples.

### (Example 1)

The pretreatment was performed on commercially available raw material graphite by the method described with reference to FIG. 3. The upper and lower grinding stones included diamonds as abrasive grains, and 5 g of graphite particles were inserted between them together with 2 mL of water. The rotating grinding stone was rotated at 10 Hz, and the pretreatment was performed on the graphite particles for around 20 seconds. The pressure at the time was 0.5 MPa.

The graphite particles after the process were classified with a sieve having an aperture of 500 µm, the graphite particles remaining on the upper surface of the sieve were extracted and dried, and they were used as the scaly graphite particles of the raw material. On the other hand, as the copper particles, copper particles having the median diameter of 1.5 µm was prepared.

Such that the copper after sintering had the volume fraction of 30%, 11.0 g of the scaly graphite particles after pretreatment and drying and 19.0 g of the copper particles were combined to obtain a raw material for molding. The powder was housed in 250 mL of an eggplant flask together with 50 mL of toluene as a solvent, the solvent was removed by an evaporator, and the product was mixed.

3 g of the raw material for molding was added to a SUS mold having a diameter of 30 mm and powder compacting was performed at a pressure of 5 MPa using a hydraulic press. Molding in which work of addition of the raw material for molding and powder compacting was repeated to the extent of exceeding 10 times was performed, and the molded body was extracted from the SUS mold.

The molded body that had been extracted was housed in a cylindrical carbon mold and was sintered by the multi-axis electric current sintering method. The carbon mold 44 was disposed in the vacuum container 42 of the multi-axis electric current sintering device 40 illustrated in FIG. 4 and was fixed with the two heating shafts (A) 47a and 47b and the two pressurization shafts (B) 45a and 45b on the diagonal lines.

The inside of the vacuum container 42 was decompressed down to 5 Pa by a rotary pump, and an output of a device power supply was increased to increase the temperature. After heating the heating shafts (A) 47a and 47b up to 700°C by the temperature rise, the heating shafts (A) 47a and 47b were changed to the heating shafts (B) 49a and 49b and heating was performed up to 950°C.

After the temperature reached 950°C, pressurization was performed to be 50 MPa with the pressurization shafts 45a and 45b. After displacement of the cylinder due to pressurization stopped, the state was held for 30 seconds, and the output of the power supply was reduced to cool the device. After cooling, the carbon mold 44 was extracted from the device to obtain a column-shaped sintered body from the inside of the mold.

The similar operation was performed five times to manufacture the five pieces of sintered bodies, thus obtaining the composite material of Example 1.

### (Example 2)

Except that the raw material for molding was changed such that the volume fraction of the copper after sintering became 16%, the composite material of Example 2 was manufactured similarly to Example 1.

### (Example 3)

Except that the raw material for molding was changed such that the volume fraction of the copper after sintering became 5%, the composite material of Example 3 was manufactured similarly to Example 1.

### (Example 4)

Except that the rotation speed of the rotating grinding stone in the pretreatment of the graphite particles was changed to 5 Hz, the composite material of Example 4 was manufactured similarly to Example 2.

### (Comparative Example 1)

Except that the rotation speed of the rotating grinding stone in the pretreatment of the graphite particles was changed to 20 Hz, the composite material of Comparative Example 1 was manufactured similarly to Example 1.

### (Comparative Example 2)

Except that the rotation speed of the rotating grinding stone in the pretreatment of the graphite particles was changed to 20 Hz, the composite material of Comparative Example 2 was manufactured similarly to Example 2.

### (Comparative Example 3)

Except that the rotation speed of the rotating grinding stone in the pretreatment of the graphite particles was changed to 20 Hz, the composite material of Comparative Example 3 was manufactured similarly to Example 3.

### (Comparative Example 4)

Except that the graphite particles without performing the pretreatment was used, the composite material of Comparative Example 4 was manufactured similarly to Example 2.

The numbers of intra-particle gaps of the composite materials of Examples and Comparative Examples were obtained to evaluate the thermal conductivities and heat deterioration rates. In all cases, five pieces of the composite materials were measured and the results were averaged.

### <Number of Intra-Scaly Graphite Particle Gaps>

As described above, the stacked cross-sectional surface in the composite material was manufactured, and the number of intra-particle gaps N was obtained following (1a) to (1c).

### <Thermal Conductivity>

To manufacture the samples for thermal conductivity measurement, first, plates were cut out in vertical directions from the centers of the columns of the composite materials of Examples and Comparative Examples. The vertical direction of the column is a direction in which the scaly graphite particles are stacked. The plate was processed to obtain a sample for thermal conductivity measurement having an outer diameter 10 mm × thickness 2.5 mm. The thickness direction of the sample is a direction perpendicular to the direction in which the scaly graphite particles are stacked (pressurization direction). The thermal conductivity of the sample was measured in the thickness direction compliant to "Method for measuring thermal diffusivity of metals by the laser flash method (JIS H 7801:2005)."

### <Heat deterioration rate>

The heat deterioration rate was obtained based on the decrease in heat diffusion rate by the temperature cycle test. The heat diffusion rate was measured using the shape and the measuring method of the measurement sample similar to the case of the laser flash method. After the heat diffusion rate TD₀ of each of the measurement samples was obtained, a cycle of temperature rise/fall from -40°C to 220°C was repeated to obtain the heat diffusion rate TD₅₀₀ at 500 times. The heat deterioration rate was calculated by ((TD₀ - TD₅₀₀)/TD₀)) × 100).

The following table 1 summarizes the obtained results together with the volume fractions of the coppers as well as the rotation speeds in the pretreatment of the graphite particles.

**[Table 1]**

| | Volume fraction of copper (%) | Rotation speed in pretreatment (Hz) | Number of intra-particle gaps (pcs) | Thermal conductivity (W/m·K) | Heat deterioration rate (%) |
|---|---|---|---|---|---|
| Example 1 | 30 | 10 | 2.4 | 744 | 3.2 |
| Example 2 | 16 | 10 | 4.2 | 804 | 3.5 |
| Example 3 | 5 | 10 | 4.8 | 822 | 1.8 |
| Example 4 | 16 | 5 | 0 | 815 | 2.3 |
| Comparative Example 1 | 30 | 20 | 7.8 | 735 | 23.1 |
| Comparative Example 2 | 16 | 20 | 7.0 | 765 | 21.9 |
| Comparative Example 3 | 5 | 20 | 12.2 | 780 | 25.5 |
| Comparative Example 4 | 16 | None | 8.9 | 753 | 18.3 |

As shown in Table 1, all of the composite materials manufactured using the scaly graphite particles on which the pretreatment was performed at the rotation speed of 10 Hz had the numbers of intra-particle gaps of 4.8 pieces or less (Examples 1 to 4). In contrast to this, the composite materials using the scaly graphite particles on which the pretreatment was performed at the rotation speed of 20 Hz (Comparative Examples 1 to 3) and the composite material using the graphite particles without performing the pretreatment (Comparative Example 4) had the numbers of intra-particle gaps of 7.0 pieces or more.

In the scaly graphite particles obtained by performing the pretreatment at the rotation speed of 12 Hz or less, the number of intra-particle gaps is limited to five pieces or less. From the results, it has been found that the rotation speed of the rotating grinding stone in the pretreatment affects the number of intra-scaly graphite particle gaps after the treatment.

Since the thermal conductivity of the composite material depends on the composition ratio between the graphite and the copper, as shown in Examples 1 to 3, when the volume fraction of the copper is reduced and the content of the graphite contributing to heat conduction increases, the thermal conductivity is improved. However, through comparison between Examples 1 to 3 and Comparative Examples 1 to 3, it is found that an increase in the rotation speed of the rotating grinding stone in the pretreatment decreases the thermal conductivity. It is inferred that the graphite particles on which the pretreatment has been performed at the rotation speed exceeding 12 Hz pass through between the grinding stones without application of sufficient stress.

It has been confirmed through shape observation with an optical microscope that the scaly graphite particles of Comparative Examples 1 to 3 are unprocessed. The thermal conductivity of the composite material using the graphite particles without performing the pretreatment (Comparative Example 4) is slightly lower than that of the composite material having the same copper volume fraction (Comparative Example 2).

As shown in Examples 1 to 4, the composite material using the scaly graphite particles on which the pretreatment had been performed at the rotation speed of 10 Hz has the heat deterioration rate of 4.8% or less. FIG. 6 illustrates transition of the heat deterioration rate in the temperature cycle test of the composite material of Example 1. Although the heat deterioration rate substantially increases by the temperature cycle by 100 times, thereafter, even when the temperature cycle is repeated, the heat deterioration rate does not significantly increase and is approximately constant. The similar tendency has been confirmed in the composite materials of Examples 2 to 4.

The composite materials using the scaly graphite particles on which the pretreatment was performed at the rotation speed of 20 Hz (Comparative Examples 1 to 3) and the composite material using the graphite particles without performing the pretreatment (Comparative Example 4) have the heat deterioration rate of 18% or more and 25.5% at the maximum.

The results indicate that the heat deterioration rate of the composite material is caused by the number of intra-scaly graphite particle gaps. It has been confirmed that by performing the adequate pretreatment, the number of intra-scaly graphite particle gaps can be controlled, and the use of such scaly graphite particles allow obtaining the graphite-copper composite material in which the heat deterioration after the temperature cycle is reduced.

### Reference Signs List

12... Scaly graphite particles
14...Copper layer
16... Gap
23...Graphite particles
30a, 30b ... Grinding stone
31a, 31b...Metal plate
32a, 32b... Joining metal member
33a, 33b...Abrasive grain
40... Multi-axis electric current sintering device
42... Vacuum container
44...Carbon mold
45a, 45b...Pressurization shaft
47a, 47b...Heating shaft
49a, 49b...Heating shaft
50.. . Heatsink
51...Wiring layer
52...Electric insulating layer
53... Stress buffer layer
54...Cooling layer
55...Cooling board

## Claims

1. A graphite-copper composite material comprising:
a copper layer (14); and
scaly graphite particles (12) stacked via the copper layer (14), wherein
a volume fraction of copper is from 3 to 30%, and
a number of intra-particle gaps (16) N obtained by the following (1a) to (1c) is five pieces or less in a stacked cross-sectional surface, wherein
(1a) defining five measurement visual fields of 930 µm × 1230 µm in the stacked cross-sectional surface;
(1b) counting the number of gaps (16) having a width of 2 to 5 µm in the scaly graphite particles (12) in each of the five measurement visual fields, and assigning N₁ to N₅ for the five measurement visual fields; and
(1c) calculating an average value of the number of gaps (16) ((N₁ + N₂ + N₃ + N₄ + N₅)/5) to obtain the number of intra-particle gaps (16) N.

2. The graphite-copper composite material according to claim 1, wherein
a thermal conductivity in a direction perpendicular to a direction in which the scaly graphite particles (12) are stacked is 700 W/(m·K) or more.

3. The graphite-copper composite material according to claim 2, wherein
a heat deterioration rate obtained by the following (2a) to (2c) is 10% or less, wherein
(2a) cutting a plate out in the direction in which the scaly graphite particles (12) are stacked to prepare a sample;
(2b) after a heat diffusion rate TD₀ of the sample is obtained, repeating a cycle of temperature rise/fall from -40°C to 220°C to obtain a heat diffusion rate TD₅₀₀ after 500 times; and
(2c) obtaining the heat deterioration rate by ((TD₀ - TD₅₀₀)/TD₀)) × 100).

4. A heat sink (50) member using the graphite-copper composite material according to any one of claims 1 to 3.

5. A method for manufacturing the graphite-copper composite material according to claim 1, comprising:
inserting graphite particles (23) between a pair of grinding stones (30a, 30b) disposed up and down and rotating a grinding stone (30a, 30b) on an upper side at 12 Hz or less to perform pretreatment on the graphite particles (23) and to obtain the scaly graphite particles (12);
mixing the scaly graphite particles (12) and copper particles to obtain a raw material for molding; and
sintering a molded body, obtained by molding the raw material for molding, by a multi-axis electric current sintering method.

## Patentansprüche

1. Graphit-Kupfer-Verbundmaterial, aufweisend:
eine Kupferschicht (14); und
schuppenförmige Graphitpartikel (12), die über die Kupferschicht (14) stapelförmig angeordnet sind, wobei der Volumenanteil an Kupfer 3 bis 30% beträgt, und
die Anzahl N der durch die folgenden Schritte (1a) bis (1c) erhaltenen Intra-Partikel-Zwischenräume (16) in einer gestapelten Querschnittsfläche fünf oder weniger beträgt,
(1a) Definieren von fünf visuellen Messfeldern mit den Abmessungen 930 µm × 1230 µm in der gestapelten Querschnittsfläche;
(1b) Zählen der Anzahl von Zwischenräumen (16) mit einer Breite von 2 bis 5 µm in den schuppenförmigen Graphitpartikeln (12) in jedem der fünf visuellen Messfelder und Zuweisen von N₁ bis N₅ für die fünf visuellen Messfelder; und
(1c) Berechnen eines Durchschnittswerts der Anzahl der Zwischenräume (16) ((N₁ + N₂ + N₃ + N₄ + N₅)/5), um die Anzahl der Intra-Partikel-Zwischenräume (16) N zu erhalten.

2. Graphit-Kupfer-Verbundmaterial nach Anspruch 1, wobei die Wärmeleitfähigkeit in einer Richtung senkrecht zu der Richtung, in der die schuppenförmigen Graphitpartikel (12) stapelförmig angeordnet sind, 700 W/(m·K) oder mehr beträgt.

3. Graphit-Kupfer-Verbundmaterial nach Anspruch 2, wobei eine durch die folgenden Schritte (2a) bis (2c) erhaltene thermische Alterungsrate 10% oder weniger beträgt,
(2a) Ausschneiden einer Platte in der Richtung, in der die schuppenförmigen Graphitpartikel (12) stapelförmig angeordnet sind, um eine Probe herzustellen;
(2b) nach dem Erhalten einer Wärmediffusionsrate TD₀ der Probe, Wiederholen eines Zyklus des Temperaturanstiegs und -abfalls von -40°C bis 220°C, um nach 500 Zyklen eine Wärmediffusionsrate TD500 zu erhalten; und
(2c) Erhalten der thermischen Alterungsrate durch ((TD₀ - TD₅₀₀)/TD₀) × 100).

4. Kühlkörperelement (50), das das Graphit-Kupfer-Verbundmaterial nach einem der Ansprüche 1 bis 3 verwendet.

5. Verfahren zum Herstellen des Graphit-Kupfer-Verbundmaterials nach Anspruch 1, aufweisend:
Einbringen von Graphitpartikeln (23) zwischen einem Paar von vertikal angeordneten Schleifsteinen (30a, 30b) und Drehen eines Schleifsteins (30a, 30b) auf der Oberseite mit 12 Hz oder weniger, um die Graphitpartikel (23) einer Vorbehandlung zu unterziehen und die schuppenförmigen Graphitpartikel (12) zu erhalten;
Mischen der schuppenförmigen Graphitpartikel (12) und der Kupferpartikel, um ein Rohmaterial für einen Formvorgang zu erhalten; und
Sintern eines Formkörpers, der durch Formen des Rohmaterials für den Formvorgang erhalten wurde, mittels eines mehrachsigen elektrischen Stromsinterverfahrens.

## Revendications

1. Matériau composite graphite-cuivre comprenant :
une couche de cuivre (14) ; et
des particules de graphite lamellaire (12) empilées par l'intermédiaire de la couche de cuivre (14), dans lequel
une fraction volumique de cuivre est de 3 à 30 %, et
un nombre d'intervalles intra-particules (16) N obtenu par les étapes (1a) à (1c) suivantes est de cinq unités ou moins dans une surface de section transversale empilée, dans lequel
(1a) définir cinq champs visuels de mesure de 930 µm x 1230 µm dans la surface de section transversale empilée ;
(1b) compter le nombre d'intervalles (16) ayant une largeur de 2 à 5 µm dans les particules de graphite lamellaire (12) dans chacun des cinq champs visuels de mesure, et affecter N₁ à N₅ aux cinq champs visuels de mesure ; et
(1c) calculer une valeur moyenne du nombre d'intervalles (16) ((N₁ + N₂ + N₃ + N₄ + N₅)/5) pour obtenir le nombre d'intervalles intra-particules (16) N.

2. Matériau composite graphite-cuivre selon la revendication 1, dans lequel
une conductivité thermique dans une direction perpendiculaire à une direction dans laquelle les particules de graphite lamellaire (12) sont empilées est de 700 W/(m· K) ou plus.

3. Matériau composite graphite-cuivre selon la revendication 2, dans lequel
un taux de détérioration thermique obtenu par les étapes (2a) à (2c) suivantes est de 10 % ou moins, dans lequel
(2a) découper une plaque dans la direction dans laquelle les particules de graphite lamellaire (12) sont empilées pour préparer un échantillon ;
(2b) après qu'un taux de diffusion thermique TD₀ de l'échantillon est obtenu, répéter un cycle de montée/chute de température de -40 °C à 220 °C pour obtenir un taux de diffusion thermique TD₅₀₀ après 500 fois ; et
(2c) obtenir le taux de détérioration thermique par ((TD₀ - TD₅₀₀)/TD₀)) x 100).

4. Élément de dissipation thermique (50) utilisant le matériau composite graphite-cuivre selon l'une quelconque des revendications 1 à 3.

5. Procédé de fabrication du matériau composite graphite-cuivre selon la revendication 1, comprenant les étapes consistant à :
insérer des particules de graphite (23) entre une paire de meules (30a, 30b) disposées en haut et en bas et faire tourner une meule (30a, 30b) sur un côté supérieur à 12 Hz ou moins pour réaliser un prétraitement sur les particules de graphite (23) et pour obtenir les particules de graphite lamellaire (12) ;
mélanger les particules de graphite lamellaire (12) et les particules de cuivre pour obtenir un matériau brut pour le moulage ; et
fritter un corps moulé, obtenue en moulant le matériau brut pour le moulage, par un procédé de frittage à courant électrique multiaxial.
